# EUROPEAN PATENT APPLICATION

(11) **EP 2 101 346 A1**
(43) Date of publication of application: **16.09.2009**
(21) Application number: 07860159.8
(22) Date of filing: 26.12.2007
(51) Int. Cl.: H01L 21/3205, G02F 1/1343, G02F 1/1368, H01L 21/285, H01L 21/336, H01L 23/52, H01L 29/417, H01L 29/423, H01L 29/49, H01L 29/78, H01L 29/786

(54) **METHOD FOR FORMING WIRING FILM, TRANSISTOR, AND ELECTRONIC DEVICE**

(30) Priority: 28.12.2006 JP 2006354858
(71) Applicant: ULVAC, INC., Chigasaki-shi Kanagawa 253-8543 (JP)
(72) Inventor: TAKASAWA, Satoru, Sammu-Shi, Chiba 289-1226 (JP); TAKEI, Masaki, Sammu-Shi, Chiba 289-1226 (JP); TAKAHASHI, Hirohisa, Sammu-Shi, Chiba 289-1226 (JP); KATAGIRI, Hiroaki, Sammu-Shi, Chiba 289-1226 (JP); UKISHIMA, Sadayuki, Sammu-Shi, Chiba 289-1226 (JP); TANI, Noriaki, Sammu-Shi, Chiba 289-1226 (JP); ISHIBASHI, Satoru, Sammu-Shi, Chiba 289-1226 (JP); MASUDA, Tadashi, Tomisato-Shi, Chiba 286-0225 (JP)
(74) Representative: Körber, Martin Hans
(86) International application number: PCT/JP2007/074930
(87) International publication number: WO 2008/081805

(57) **Abstract**

A wiring film having excellent adhesion and a low resistance is formed. A barrier film 22 having copper as a main component and containing oxygen is formed on an object 21 to form a film thereon by introducing an oxygen gas into a vacuum chamber 2 in which the object 21 to form a film thereon and sputtering a pure copper target 11. Then, after the introduction of the oxygen gas is stopped, a low-resistance film 23 made of pure copper is formed by sputtering the pure copper target 11. Since the barrier film 22 and the low-resistance film 23 have copper as the main component, they can be patterned at a time. Since the low-resistance film 23 has a resistance lower than that of the barrier film 22, the resistance of the whole wiring film 25 is reduced. Since the barrier layer 22 has high adhesion to glass and silicon, the whole wiring film 25 has high adhesion.

## Description

### TECHNICAL FIELD

The present invention relates to the field of wiring film, and particularly the invention relates to a wiring film for transistors and a process for forming such a wiring film.

### BACKGROUND ART

The present invention relates to the field of wiring film, and more particularly, the invention relates to a wiring film for transistors and a process for forming such a wiring film.

Heretofore, low-resistance materials (such as, Al, Cu, etc.) have been used in metallic wiring films for electric parts. For instance, in the case of the TFT (thin film transistor) liquid crystal displays, a demand for the reduction in the resistance of the wiring electrodes has been increasing with the enlargement of the panels, and the necessity for using Al and Cu as the low-resistance wirings has been growing.

When an Al wiring composed mainly of Al contacts an oxide (such as, Si02, ITO (indium tin oxide) or the like), hillock can be formed with oxygen of the oxide. In addition, when the Al wiring is used as source and drain electrodes of a TFT, there are problems of diffusion into an underlying Si layer and a degradation in a contact resistance between a transparent electrode made of ITO.

On the other hand, as to the Cu wiring, Cu is a material having a lower resistance than that of Al. Although degradation in the contact resistance between Al and the ITO transparent electrode poses a problem, Cu exhibits an excellent contact resistance because Cu is more difficult to be oxidized than Al.

Therefore, a need to use Cu for low-resistance wiring films has been increasing. However, as compared to other wiring materials, there are problems in that Cu has poor adhesion to underlying materials (such as glass, Si or the like), and Cu diffuses into the Si layer when it is used as the source and drain electrodes. Thus, a barrier layer is required at an interface between the Cu wiring and other layers so as to enhance the adhesion and prevent the diffusion.

Regarding an underlying Cu seed layer made of a Cu plating, which is used in a semiconductor, a barrier layer is required to prevent the diffusion of TiN, TaN or the like from the same above-mentioned diffusion problem.

As to related patents on metallic wiring films composed mainly of Cu for electronic parts, a technique characterized by adding an element such as Mo or the like into Cu (JP-A 2005-158887) and a technique characterized by introducing nitrogen or oxygen during a film-forming process by sputtering pure Cu (JP-A 10-12151) are known. However, both of the above-mentioned conventional techniques have problems in reducing resistance, etc.
Patent Document: JP-A 2005-158887
Patent Document: JP-A 10-12151

### DISCLOSURE OF THE INVENTION

### PROBLEM TO BE SOLVED BY THE INVENTION

The present invention has been accomplished to solve the above-mentioned problems, and its object is to provide a low-resistance wiring film having high adhesion to the glass substrate and the silicon layer.

### MEASURES TO SOLVE THE PROBLEMS

The present invention is directed to a wiring film-forming process for forming a wiring film on a surface of an object to form a film thereon to which a silicon or a silicon dioxide is exposed, the wiring film-forming process including the steps of: introducing an oxide gas and a sputtering gas into a vacuum atmosphere in which the object to form a film thereon is disposed, sputtering a first pure copper target in the vacuum atmosphere including oxygen, forming a barrier film on a surface of the object to form a film thereon, thereafter sputtering a second pure copper target in the state that the introduction of oxygen gas into a vacuum atmosphere in which the object to form a film thereon is disposed is stopped, forming a low-resistance film on a surface of the barrier film, etching the barrier film and the low-resistance film, and thereby forming the wiring film. The present invention is directed to a wiring film-forming process, wherein an identical target is used as the first and second pure targets, and the formation of the barrier film and the formation of the low-resistance film are performed inside the same vacuum chamber.

The present invention is directed to a wiring film-forming process, wherein the barrier film is formed by sputtering the first copper target, with an oxygen gas introduced such that a ratio of the partial pressure of the oxygen gas to the partial pressure of the sputtering gas in the vacuum atmosphere is at least 3.0%.

The present invention is directed to a wiring film-forming process, wherein after the low-resistance film is formed, the oxygen gas and the sputtering gas are introduced into the vacuum atmosphere in which the object to form a film thereon is disposed, an adhering film is formed on a surface of the low-resistance film by sputtering a third pure copper target in a vacuum atmosphere including oxygen, and thereafter the wiring film is formed by etching the barrier film, the low-resistance film and the adhering film.

The present invention is directed to a wiring film-forming process, wherein a same target is used as the first to third pure copper targets, and wherein the formation of the barrier film, the formation of the low-resistance film and the formation of the adhering film are performed inside a same vacuum chamber.

The present invention is directed to a wiring film-forming process, wherein discrete targets are used as the first to third pure copper targets, and wherein the formation of the barrier film, the formation of the low-resistance film and the formation of the adhering film are performed inside discrete vacuum chambers.

The present invention is directed to a wiring film-forming process, wherein an identical target is used as the first and third pure copper targets, another target, different from that used as the first and third pure copper targets, is used as the second pure copper target, the formation of the barrier film and the formation of the adhering film are performed in the same vacuum chamber, and the formation of the low-resistance film is performed in another vacuum chamber, which is different from the vacuum chamber used for the formation of the barrier film and the adhering film.

The present invention is directed to a transistor, comprising a gate electrode, a drain semiconductor layer and a source semiconductor layer composed of semiconductors, respectively, wherein the drain semiconductor layer and the source semiconductor layer being configured to be cut off or electrically turned on therebetween by applying a voltage to the gate electrode, wherein a barrier film having copper as a main component and including oxygen is formed on at least one of the surfaces of the drain semiconductor layer and that of the source semiconductor layer, and a low-resistance layer including copper as a main component and having a resistance lower than that of the barrier film is formed on a surface of the barrier film.

The present invention is directed to a transistor, wherein an adhering film, including copper as a main component and including oxygen, is formed on either one or both surfaces of the low-resistance film on the source semiconductor film and the low-resistance film on the drain semiconductor layer.

The present invention is directed to a transistor having a gate electrode, a drain semiconductor layer composed of a semiconductor, and a source semiconductor electrode composed of a semiconductor, the drain semiconductor layer and the source semiconductor layer being configured to be cut off or electrically turned on therebetween by applying a voltage to the gate electrode, and the gate electrode contacting a glass substrate, wherein the gate electrode has a barrier film formed on a surface of the glass substrate and a low-resistance film formed on a surface of the barrier film, wherein the barrier film has copper as a main component and includes oxygen, and wherein the low-resistance film has copper as a main component and has a resistance lower than that of the barrier film.

The present invention is directed to an electronic device having a transistor, the transistor having a gate electrode, a drain semiconductor layer and a source semiconductor layer composed of semiconductors, respectively, the drain semiconductor layer and the source semiconductor layer being configured to be cut off or electrically turned on therebetween by applying a voltage to the gate electrode, wherein a barrier film having copper as a main component and including oxygen is formed on at least one of the surfaces of the drain semiconductor layer and the source semiconductor layer, and a low-resistance film having copper as a main component and having a resistance lower than that of the barrier film is formed on a surface of the barrier film.

The present invention is directed to an electronic device comprising a transistor, the transistor having a gate electrode, a drain semiconductor layer composed of a semiconductor and a source semiconductor layer composed of a semiconductor, the drain semiconductor layer and the source semiconductor layer being configured to be cut off or electrically turned on therebetween by applying a voltage applied to the gate electrode, and the gate electrode contacting a glass substrate, wherein the gate electrode has a barrier film formed on a surface of the glass substrate and a low-resistance film formed on a surface of the barrier film, wherein the barrier film has copper as a main component and includes oxygen, and wherein the low-resistance film has copper as a main component and has a resistance lower than that of the barrier film.

The present invention is directed to an electronic device having a glass substrate, a transparent pixel electrode arranged on the glass substrate, liquid crystals disposed on the pixel electrode, a transparent common electrode arranged on the liquid crystals, and a storage electrode tightly adhered to the glass substrate, wherein a storage capacity having the storage electrode as a one-side electrode is connected to a liquid crystal capacity formed between the pixel electrode and the storage electrode, and the orientation of the liquid crystals is controlled by charging and discharging the liquid crystal capacity, wherein the storage electrode has a barrier film formed on a surface of the glass substrate and a low-resistance film formed on a surface of the barrier film, wherein the barrier film has copper as a main component and includes oxygen, and wherein the low-resistance film has copper as a main component and has a resistance lower than that of the barrier film.

In the present invention, the term "main" in "main component" means that the element as this main component is contained at not less than 50 atomic%. Therefore, "copper as a main component" means "copper atoms are contained at not less than 50 atomic%".

An element (for example, Mn, Mg or the like) other than Cu may however be mixed in the pure copper target used in the present invention as an impurity. The content of the impure element is less than 0.1 atomic%, and ordinarily less than 10⁻⁴ atomic%. In the wiring film of the present invention formed by using such a pure copper target, the content of the impurity other than Cu and oxygen is less than 0.1 atomic%, and ordinarily less than 10⁻⁴ atomic%.

### EFFECTS OF THE INVENTION

The wiring film formed by the present invention has high adhesion to silicon and glass and has low resistance. Since the patterning in forming the wiring film can be performed by patterning the barrier film and the low-resistance film with an identical etchant at a time, the production steps in forming the wiring film of the present invention are simple.

### BRIEF DESCRIPTION OF THE DRAWINGS

Fig. 1 is a sectional view for illustrating one embodiment of a sputtering apparatus to be used in the present invention.
Figs. 2(a) to (e) are sectional views for illustrating one example of steps of forming the wiring film of the present invention.
Fig. 3 is a sectional view for illustrating one embodiment of the liquid crystal display device of the present invention.
Fig. 4 is a sectional view for illustrating one embodiment of the semiconductor device of the present invention.
Figs. 5(a) and (b) are sectional views for illustrating another example of steps of forming the wiring film of the present invention.
Fig. 6 is a sectional view for illustrating a second embodiment of the sputtering apparatus.
Fig. 7 is a sectional view for illustrating a third embodiment of the sputtering apparatus.

### EXPLANATION OF REFERENCE NUMERALS

1 --- sputtering apparatus, 2 --- vacuum chamber, 3 --- liquid crystal display device, 6 --- semiconductor device, 11 --- pure copper target, 31 --- glass substrate, 22 --- barrier film, 23 --- low-resistance film, 24 --- laminated film, 25, 27wiring film, 36 --- pixel electrode, 38 --- storage electrode, 40 --- transistor (TFT), 41 --- gate electrode, 42 --- drain electrode, 43 --- source electrode, 46 --- channel semiconductor layer, 47 --- drain semiconductor layer, 48source semiconductor layer, 55 --- common electrode

### BEST MODE FOR CARRYING OUT THE INVENTION

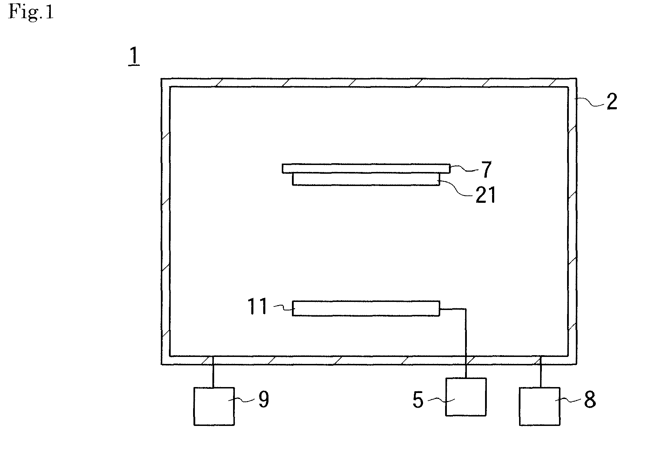

In Fig. 1, a reference numeral 1 denotes a first embodiment of a sputtering apparatus to be used in the present invention.

This sputtering apparatus 1 has a vacuum chamber 2; and a pure copper target 11 is arranged inside the vacuum chamber 2. The content of impurity elements other than copper in the pure copper target 11 is less than 0.1 atomic%.

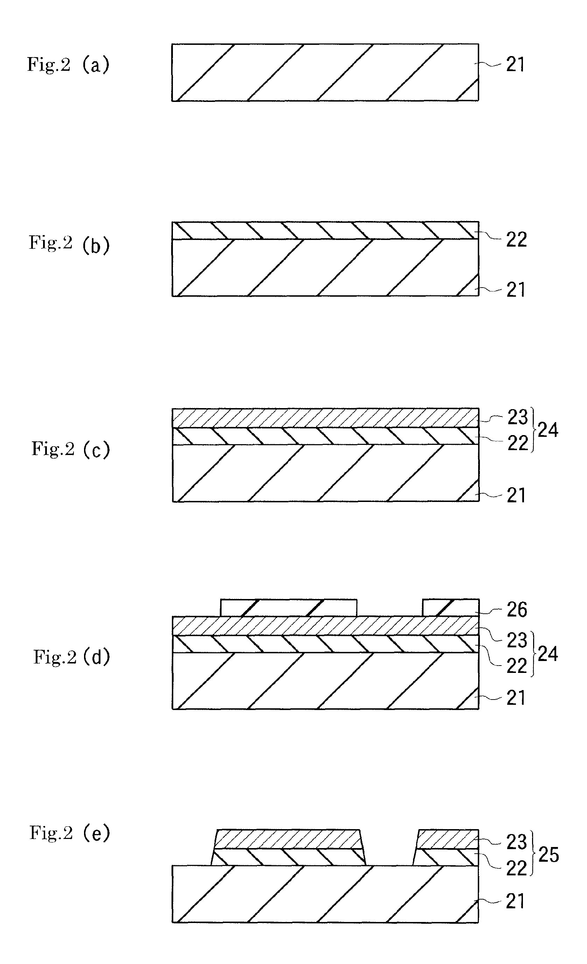

In Fig. 2(a), a reference numeral 21 denotes an object to form a film thereon; and a surface of a semiconductor area or a glass substrate is exposed at a surface thereof.

A vacuum evacuation system 9 and a gas introduction system 8 are connected to the vacuum chamber 2; the interior of the vacuum chamber 2 is evacuated to a vacuum state by the vacuum evacuation system 9; the object 21 to form a film thereon is carried therein in the state of an vacuum atmosphere; and the object is held by a substrate holder 7 arranged inside the vacuum chamber 2.

A sputtering gas source and an oxygen gas source are connected to the gas introduction system 8 such that a sputtering gas and an oxygen gas may be introduced into the vacuum chamber 2, while the flow rates are being controlled.

A sputtering electric power source 5 is connected to the pure copper target 11. After the interior of the vacuum chamber 2 is evacuated to vacuum, the sputtering gas or both the sputtering gas and the oxygen gas are introduced from the gas introduction system 8. When a voltage is applied to the pure copper target 11 by the sputtering electric power source 5, a plasma of the introduced gas is formed near the surface of the pure copper target 11.

When the pure copper target 11 is sputtered with the plasma, copper atoms or fine copper particles made of atom groups are emitted toward the object 21 to form a film thereon. When they reach a surface of the object 21 to form a film thereon, they react with oxygen, a barrier film 22 made of copper and copper oxide is formed on a surface of the object 21 to form a film thereon as shown in Fig. 2(b).

The barrier film 22 is grown by sputtering the pure copper target 11, while oxygen is being introduced. When the barrier film 22 is formed in a film thickness of 10nm or more, the introduction of the oxygen gas is stopped. While the vacuum evacuation and the introduction of the sputtering gas are continued, a low-resistance film 23 of pure copper is formed on a surface of the barrier film 22 by sputtering the same pure copper target 11 with the sputtering gas (Fig. 2(c)).

When the low-resistance film 23 is formed in a predetermined film thickness, the object 21 to form a film thereon is carried out of the sputtering apparatus 1. As shown in Fig. 2(c), a laminated film 24 having the barrier film 22 and the low-resistance film 23 is formed on the surface of the object 21 to form a film thereon. The barrier film 22 tightly adheres to the surface of the semiconductor area or the glass substrate being exposed at the surface of the object 21 in order to form a film thereon; and the low-resistance film 23 is disposed on the surface of the barrier film.

Next, when a patterned resist film 26 is disposed on a surface of the laminated film 24 as shown in Fig. 2 (d) and the laminated film 24 exposed at bottom faces of the resist film 26 are subjected to an etching liquid or an etching gas of a weak acid or the like, a patterned wiring film 25 is formed as shown in Fig. 2(e).

The sectional shape of this wiring film 25 is a trapezoidal shape with taper portions, in which the width of a bottom face side is longer than that of an upper portion.

Since the barrier film 22 and the low-resistance film 23 are made of copper or both copper and copper oxide, they can be etched with the etching liquid (or an etching gas) having the same composition, so that it is unnecessary to again arrange a new resist film in etching the barrier film 22.

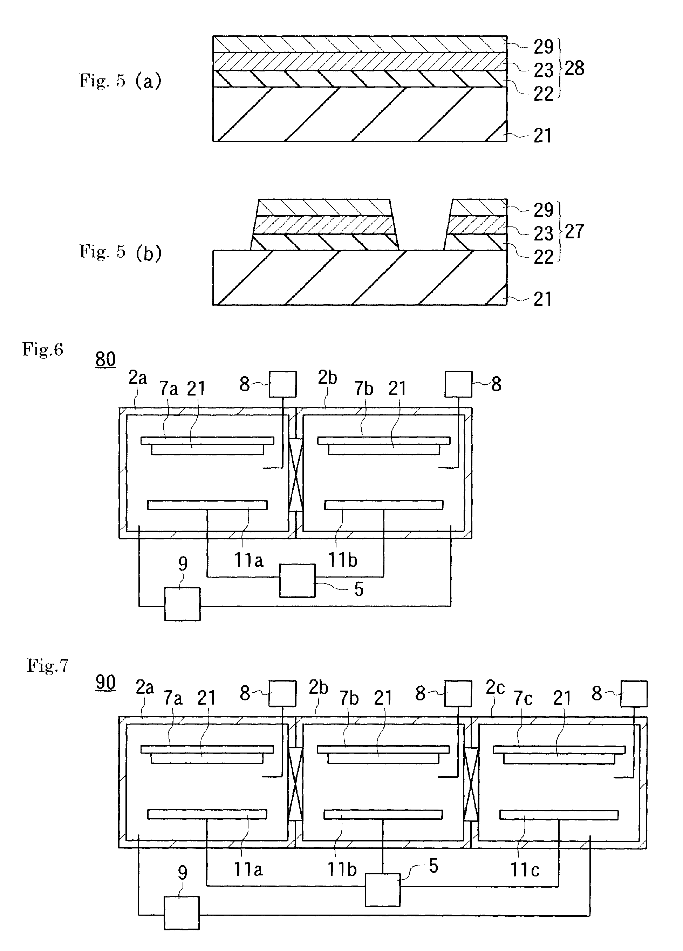

In the above embodiment, although the barrier film 22 and the low-resistance film 23 are formed inside the vacuum chamber 2 of the same sputtering apparatus 1, the present invention is not limited thereto. As shown in Figs. 6 and 7, discussed later, the barrier film 22 and the low-resistance film 23 may be formed by sputtering separate targets in different vacuum chambers.

However, if the barrier film 22 and the low-resistance film 23 are continuously formed inside the same sputtering apparatus 1, the film quality is improved since neither the barrier film 22 nor the low-resistance film 23 is exposed to the atmosphere.

The above-mentioned object 21 to form a film thereon is a TFT substrate or a substrate to be used in a semiconductor device, as discussed later; and a glass substrate, silicon or the like is exposed at a part or an entire part of the surface thereof.

Adhesion of the barrier film 22 made of copper and copper oxide to the glass substrate or the semiconductor area is higher than adhesion of a thin film of pure copper to the glass substrate or the semiconductor area (silicon single crystal, polycrystal or the like).

In the present invention, the low-resistance film 23 is firmly connected onto the glass substrate or the semiconductor area by the barrier film 22; and it is thus hardly peeled.

The diffusion amount of copper into silicon oxide or the semiconductor area is larger when a thin film of pure copper (low-resistance film) is disposed on the barrier film 22 made of copper oxide and copper than the diffusion amount of copper into silicon oxide or the semiconductor area when a barrier film is formed of a high melting point metal (such as Ti, W or the like) and a thin film of pure copper is formed thereon, but smaller when the pure copper film is disposed in contact with the silicon oxide or the semiconductor area without the provision of the barrier film 22. Therefore, the wiring film formed by the present invention can also be required as a low-resistance wiring film in the semiconductor device field.

In the case of a liquid crystal display device having a transparent electroconductive film of an oxide (such as, ITO, ZnO or the like), after the above-mentioned low-resistance film 23 of pure copper is formed, an adhering film 29 composed of copper oxide and copper is formed in a film thickness of 10nm or more on the low-resistance film 23 by sputtering the pure copper target 11, while oxygen is being introduced into the vacuum atmosphere in which the pure copper target 11 is arranged (Fig. 5(a)). A transparent electroconductive film of an oxide can be disposed tightly adhering to this adhering film 29.

In such a case, since oxygen is contained in the adhering film 29, the oxygen in the transparent oxide electroconductive film is prevented from diffusing into the low-resistance layer 23.

Since the adhering film 29 is made of copper and copper oxide similar to the make up of the barrier film 22, the adhering film 29 can be etched with the same etchant (etching liquid or etching gas) as in the case of the barrier film 22 and the low-resistance film 23. Consequently, a patterned wiring film 27 can be formed by etching a laminated film 28 composed of the barrier film 22, the low-resistance film 23 and the adhering film 29 (Fig. 5(b)).

In the above descriptions, explanation has been provided for the case where the barrier film 22, the low-resistance film 23 and the adhering film 29 are formed by sputtering the same pure copper target 11 in the same vacuum chamber 2, but the present invention is not limited thereto.

In Fig. 6, a reference numeral 80 denotes a second embodiment of the sputtering apparatus, whereas a reference numeral 90 in Fig. 7 denotes a third embodiment of the sputtering apparatus. The second and third embodiments of the sputtering apparatus 80, 90 comprise a first vacuum chamber 2a, a second vacuum chamber 2b connected to the first vacuum chamber 2a, a first pure copper target 11a arranged inside the first vacuum chamber 2a, and a second pure copper target 11b arranged inside the second vacuum chamber 2b.

The following description pertains to the steps for forming a laminated film for a wiring film by using the second and third embodiments of the sputtering apparatuses 80, 90.

First, a vacuum atmosphere is formed inside the first and second vacuum chambers 2a, 2b by the vacuum evacuation system 9. While the vacuum atmosphere is being maintained, an object 21 having a film to be formed thereon is carried into the first vacuum chamber 2a, and held by a substrate holder 7a.

While vacuum evacuation is being continued, the sputtering gas and the oxygen gas are introduced into the first vacuum chamber 2a from the gas feeding system 8, a voltage is applied to the first pure copper target 11a from an electric power source 5, and a barrier film 22 is formed by sputtering the first pure copper target 11a in the vacuum atmosphere containing oxygen.

The object 21 with the barrier film 22 formed thereon is carried from the first vacuum chamber 2a into the second vacuum chamber 2b, and held by a substrate holder 7b. While the interior of the second vacuum chamber 2a is being evacuated to vacuum, the sputtering gas is introduced, and a low-resistance film 23 is formed by sputtering the second pure copper target 11b in the vacuum atmosphere containing no oxygen.

When an adhering film 29 is further to be formed on a surface of the low-resistance film 23, the object 21 with the low-resistance film 23 formed thereon is returned from the second vacuum chamber 2b to the first vacuum chamber 2a in the case of the second embodiment of the sputtering apparatus 80. While the interior of the first vacuum chamber 2a is being evacuated to vacuum, the sputtering gas and the oxygen gas are introduced; and the adhering film 29 is formed by sputtering the first pure copper target 11a in the vacuum chamber containing oxygen.

On the other hand, in the third embodiment of the sputtering apparatus 90, a third vacuum chamber 2c is connected to the second vacuum chamber 2a; and the object 21 formed with the low-resistance film 23 is carried from the second vacuum chamber 2b into the third vacuum chamber 2c, and held by a substrate holder 7c.

A third pure copper target 11c is arranged inside the third vacuum chamber 2c. While the inside of the third vacuum chamber 2c is being evacuated to vacuum, the sputtering gas and the oxygen gas are introduced, and an adhering film 29 is formed by sputtering the third pure copper target 11c in the vacuum atmosphere containing the oxygen gas.

In the second and third embodiments of the sputtering apparatuses 80, 90, different vacuum atmospheres (the vacuum atmosphere containing oxygen and the atmosphere containing no oxygen) are formed inside the separate vacuum chambers 2a to 2c. Accordingly, it does not take a long time to perform the vacuum evacuation until a next film is formed after the formation of one film is terminated, as compared to the sputtering apparatus 1 of the first embodiment in which the different vacuum atmospheres are alternately formed in the same vacuum chamber 2.

Further, in order to lower the resistance of the entire wiring film 27, the low-resistance film 23 is made thicker than the barrier film 22 and the adhering film 29. Therefore, the film-forming time period for the low-resistance film 23 is longer than the film-forming time period for the barrier film 22 and the adhering film 29. If a film requiring a longer film-forming time period is formed in an exclusive vacuum chamber as in the second and third embodiments of the sputtering apparatuses 80, 90, the productivity is enhanced.

Further, if, as in the third embodiment of the sputtering apparatus 90, the number of the vacuum chambers 2a to 2c is the same as that of the copper films constituting the wiring film 27 and the respective copper films are formed in the exclusive vacuum chambers 2a to 2c, the productivity is further enhanced.

As to the second embodiment of the sputtering apparatus 80, the first and second vacuum chambers 2a, 2b may be directly connected as shown in Fig. 6, or in the alternative, the first and second vacuum chambers 2a, 2b may be connected to the same transfer chamber so that the object 21 to form a film thereon may be carried in and out between the first and second vacuum chambers 2a, 2b via the transfer chamber.

Meanwhile, as to the third embodiment of the sputtering apparatus 90, the first to third vacuum chambers 2a to 2c may be connected in series as shown in Fig. 7 so that the object 21 having a film to be formed thereon may be transferred from the first vacuum chamber 2a to the third vacuum chamber 2c via the second vacuum chamber 2b. Alternatively, the first to third vacuum chambers 2a to 2c may be connected to the same transfer chamber so that the object 21 for a film to be formed thereon may be carried in and out among the first to third vacuum chambers 2a to 2c via the transfer chamber.

In any of the above-mentioned cases, since the object 21 to form a film thereon moves between or among the vacuum chambers without contacting the atmosphere, the wiring films 25, 27 having a good film quality are obtained.

Next, one embodiment of the electronic device according to the present invention will be explained.

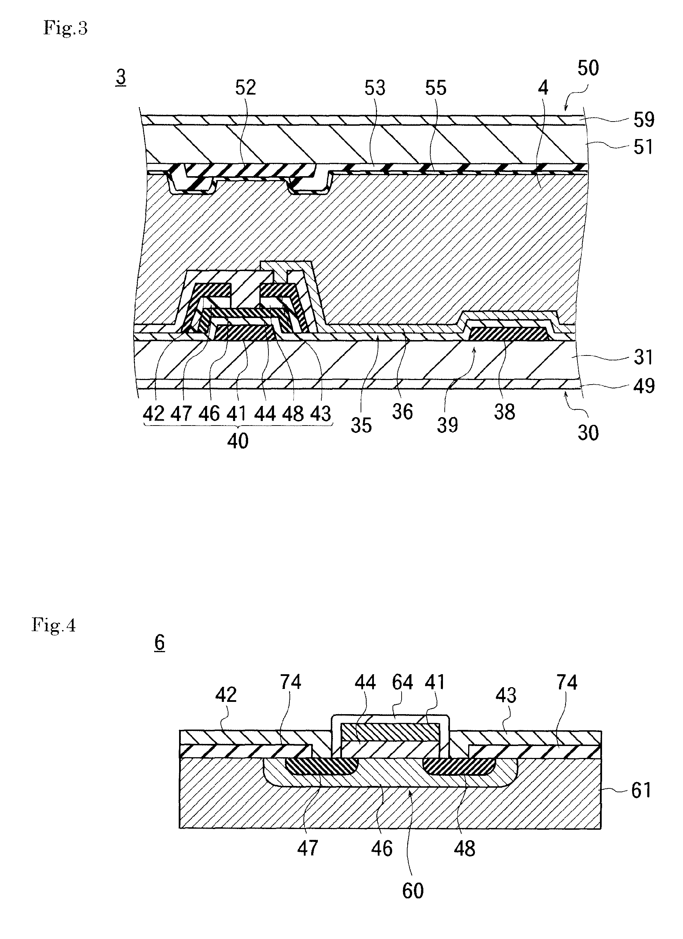

In Fig. 3, a reference numeral 3 denotes an electronic device (liquid crystal display device) with a wiring film of the present invention, which has a TFT substrate 30 and a color substrate 50.

This liquid crystal display device 3 is an active type; the TFT substrate 30 has a glass substrate 31; and a TFT (thin film transistor) 40, a display pixel 35, and a storage condenser 39 are disposed on the glass substrate 31.

The TFT 40 has a gate electrode 41, a drain electrode 42 and a source electrode 43; the storage condenser 39 has a storage electrode 38; and the display pixel 35 has a pixel electrode 36. The gate electrode 41, the drain electrode 42, the source electrode 43 and the storage electrode 38 are constituted with wiring films 25, 27, as explained above.

Further, the TFT 40 has a gate insulating film 44, a channel semiconductor layer 46, a drain semiconductor layer 47 and a source semiconductor layer 48.

The drain semiconductor layer 47 and the source semiconductor layer 48 are arranged apart from each other and in contact with one face of the channel semiconductor layer 46. The gate insulating film 44 and the gate electrode 41 are arranged at that face on a side opposite to the channel semiconductor layer 46 in a position between the drain semiconductor layer 47 and the source semiconductor layer 48.

The drain electrode 42 and the source electrode 43 are arranged in contact with the surfaces of the source semiconductor layer 48 and the drain semiconductor layer 47, respectively.

The gate electrode 41, the drain electrode 42 and the source electrode 43 are extended outside the TFT 40 so that a voltage can be applied from an exterior electric power source.

The channel semiconductor layer 46, and the drain and source semiconductor layers 47, 48 are constituted of amorphous silicon, a polysilicon or the like.

The drain semiconductor layer 47 and the source semiconductor layer 48 are of the same electroconductive type of a p-type or n-type electroconductive type, and the channel semiconductor layer 46 is the same electroconductive type as or an opposite electroconductive type to the drain semiconductor layer 47 and the source semiconductor layer 48.

First, a case where the channel semiconductor layer 46 is of the same electroconductive type as that of the source and drain semiconductor layers 47, 48 will be explained.

The channel semiconductor layer 46 has a lower resistance with a higher impurity concentration than the drain and source semiconductor layer 47, 48.

When an operating voltage is applied between the drain electrode 42 and the source electrode 43, a gate voltage is applied to the gate electrode, a voltage applied to a surface of the channel semiconductor layer 46 is applied to the gate electrode 41, the gate voltage induces a charge having the same polarity as the channel semiconductor layer 46 and the drain and the source semiconductor layer and 48 on a surface of the channel semiconductor layer, thereby a low-resistance storage layer is formed at a portion of the channel semiconductor layer 46 above the gate electrode 41, so that the drain semiconductor layer 47 and the source semiconductor layer 48 are connected through the storage layer and the TFT is electrically turned on. No storage layer is formed as long as the gate voltage is not applied, so that the TFT 40 is electrically cut off.

Next, a case where the channel semiconductor layer 46 and the source and drain electrodes 47, 48 are of different electroconductive types will be explained. When such a voltage that induces charges having a polarity opposite to that of the channel semiconductor layer 46 onto a surface of the channel semiconductor layer 46 is applied to the gate electrode 41 in a state such that an operating voltage is applied between the drain electrode 42 and the source electrode 43, an inversion layer being the same electroconductive type as that of the source and drain electrodes 47, 48 is formed at a portion of the channel semiconductor layer 46 above the gate electrode 41, so that the drain semiconductor layer 47 and the source semiconductor layer 48 are connected through the inversion layer, and the TFT is electrically turned on. No inversion layer is formed as long as no gate voltage is applied, and the TFT 40 is cut off.

A part of the surface of the source electrode 43 is exposed, and a pixel electrode 36 extended from the display pixel 35 contacts the exposed part of the source electrode 43.

The pixel electrode 36 is extended up to a position where the storage condenser 39 is located, and is arranged opposed to the storage electrode 38 disposed on the glass substrate 31 through an insulating film (gate insulating film 44). Accordingly, the storage capacity is formed by an opposed portion.

Therefore, the electrode on one side of the storage capacity is the storage electrode 38, and the electrode on the other side is the pixel electrode 36. The electrode on the other side is not limited to the pixel electrode 36, and it may be another electrode (a common electrode 55, for example).

The TFT substrate 30 and the color filter substrate 50 are placed away by a constant distance, and liquid crystals 4 are sealed therebetween.

In the color filter substrate 50, a black matrix 52 is arranged at a position opposed to the TFT 40; and a color filter 53 is arranged at a position opposed to the display pixel 35. The common electrode 55 is arranged at least at a portion of the color filter substrate 50 opposed to the display pixel 35. The pixel electrode 36 and the common electrode 55 are constituted of transparent metallic films of ITO or the like.

The TFT substrate 30 and the color filter substrate 50 have polarization plates 49, 59, respectively. When a voltage is applied between the pixel electrode 36 and the common electrode 55 by turning on or cutting off of the TFT 40, the orientation of the liquid crystals 4 above the display pixel 35 is changed, so that the polarized direction of the light passing the liquid crystals 4 are changed, thereby controlling transmission of the light irradiated to the display pixel 35 to the outside of the liquid crystal display device 3 and the shielding thereof.

The storage capacity is connected in parallel to a liquid crystal capacity formed between the pixel electrode 36 and the common electrode 55. When the TFT 40 is electrically conducted and the liquid crystal capacity between the pixel electrode 36 and the common electrode 55 is charged by the voltage of the power supply voltage via the TFT 40, the storage capacity is charged by the power supply voltage.

Even when the TFT 40 is cut off by charges stored in the storage capacity to cut off the pixel electrode 36 from the power supply voltage, the same voltage as in the case of the state of turning on of the TFT 40 is applied to the pixel electrode 36, so that the deflected state of the liquid crystals 4 above the display pixel 35 is maintained. When this liquid crystal capacity is discharged, the deflected state of the liquid crystals 4 is changed.

The storage electrode 38 and the gate electrode 41 contact the glass substrate 31, and the drain electrode 42 and the source electrode 43 contact the semiconductor layers (the drain semiconductor layer 47 and the source semiconductor layer 48).

The storage electrode 38, the gate electrode 41, the drain electrode 42 and the source electrode 43 are constituted of the wiring films 25 and 27 formed by the present invention; and the barrier film 22 contacts the glass substrate 31 or the semiconductor layers 47, 48. Therefore, adhesion among the storage electrode 38, the gate electrode 41 and the glass substrate 31 and adhesion among the drain electrode 42, the source electrode 43 and the semiconductor layers 47, 48 are high. Meanwhile, since the low-resistance film 23 arranged on the barrier film 22 contains no oxygen and has a lower resistance than the barrier film 22, the resistance in an extending direction of each electrode film (the direction orthogonal to that of the film thickness) is low.

The electronic device according to the present invention is not limited to the liquid crystal display device.

In Fig. 4, a reference numeral 6 denotes a part of a semiconductor device as another embodiment of the electronic device according to the present invention. In Fig. 4, a transistor 60 of the semiconductor device 6 is shown.

This transistor 60 has the same parts as those of the TFT 40 shown in the above Fig. 3 except that it is not disposed on a glass substrate but has a semiconductor substrate (silicon substrate) 61. Thus, explanation is omitted for the same reference numerals used for the same parts.

In this transistor 60, portions of the surfaces of the source semiconductor layer 48 and the drain semiconductor 47 are also exposed; and a barrier film 22 of the source electrode 43 and a barrier film 22 of the drain electrode 42 tightly adhere to the exposed portions, respectively.

Consequently, adhesion of the drain electrode 42 and the source electrode 43 to the silicon substrate 61 is high, and the barrier film 22 prevents copper from diffusing into the silicon substrate 61.

Further, a reference numeral 64 of Fig. 4 denotes an insulating film in order to insulate the drain electrode 42 and the source electrode 43 from the gate electrode 41; and a reference numeral 74 of the same figure denotes an insulating film in order to insulate the drain electrode 42 and the source electrode 43 from a place other than the source semiconductor layer 48 and the drain semiconductor layer 47 of the silicon substrate 61.

In a case where the electronic device is the semiconductor device 6, the drain semiconductor 47, the source semiconductor 48 and the channel semiconductor layer 46 are formed by diffusing impurities into the silicon substrate 61. In a case where the electronic device is the liquid crystal display device, the semiconductor device 6, the drain semiconductor 47, the source semiconductor 48 and the channel semiconductor layer 46 are formed by tightly adhering semiconductors such as silicon on the surface of the glass substrate 31 according to a CVD method or the like.

Further, the insulating films such as the gate insulating film 44 or the like are constituted of a nitride film of silicon nitride such as, silicon nitride or the like, an oxide film such as silicon oxide or the like.

The above description explains a case where the gate electrode 41, the drain electrode 42, the source electrode 43 and the storage electrode 38 are constituted of the wiring film 25, 27 formed by the present invention, respectively, but the present invention is not limited thereto. After either one or both of the source electrode 43 and the drain electrode 42 are formed by the wiring film-forming method of the present invention, the gate electrode 41 and the storage electrode 38 may be formed by a method different from the present invention. Alternatively, after either one or both of the gate electrode 41 and the storage electrode 38 are formed by the wiring film-forming method of the present invention, the source electrode and the drain electrode may be formed by a method different from the present invention.

In addition, all of the source electrode 43, the drain electrode 42, the gate electrode 41 and the storage electrode 38 may be constituted of the wiring film 25 with the two-layer structure or all the electrodes may be constituted of the wiring film 27 with the three-layer structure. Furthermore, with one or more of the source electrode 43, the drain electrode 42, the gate electrode 41 and the storage electrode 38 being constituted of the wiring film 25 with the two-layer structure, the remaining electrode or electrodes may be constituted of the wiring film 27 with the three-layer structure. As discussed above, since the adhering film 29 prevents oxygen from diffusing into the low-resistance film 23, the wiring film 27 with the three-layer structure is effectively used as a film contacting an electrode formed by an oxide transparent conductive film (such as the pixel electrode 36 or the common electrode 55).

### EXAMPLES

Glass substrates were used as the object 21 to form a film thereon, and barrier films 22 were formed as to the respective combinations of film forming conditions: ratios of the partial pressure of the oxygen gas to that of the sputtering gas (Ar) at the time of sputtering and the annealing temperatures after the film formation.

In each combination, the introduction of sputtering gas was set such that the partial pressure of the introduced amount was a constant value (0.4Pa). The ratio of the partial pressure of the oxygen gas to the partial pressure of the sputtering gas is a value obtained by dividing the partial pressure of the oxygen gas by the partial pressure of the sputtering gas (0. 4Pa) and multiplying the quotient by 100.

### <Adhesion>

A total of 100 1mm grid squares were inscribed in 10 lines × 10 columns on each barrier film 22 with a tip-sharp cutter knife, and an adhesive tape (No. 610 Scotch tape) was stuck thereto. Then, the number of the remaining barrier films 22 after the adhesive tape was peeled was counted. Results thereof are given in the following Table 1 together with the ratios of the partial pressure of the oxygen gas to the partial pressure of the sputtering gas and the annealing temperature. The unit of the annealing temperature in Table 1 below is °C.

Tab.1

**Table 1 : Adhesion test**

| O₂ ratio [%] | Annealing temperature | | |
|---|---|---|---|
| | Not annealed | 350 | 450 |
| 0 | 30/100 | 28/100 | 35/100 |
| 0.1 | 48/100 | 52/100 | 57/100 |
| 3.0 | 77/100 | 81/100 | 79/100 |
| 10.0 | 92/100 | 93/100 | 91/100 |
| 20.0 | 99/100 | 97/100 | 98/100 |

When all the barrier film 22 was peeled from the glass substrate, the evaluation was 0/100, whereas when none was peeled, the evaluation was 100/100. Thus, the greater the number of the numerator, the higher is the adhesion.

As seen from the above Table 1, the higher the partial pressure of the oxygen gas, the greater the adhesion. When the ratio of the partial pressure of the oxygen gas to the partial pressure of the sputtering gas is not less than 3.0%, more than half of the barrier film 22 remains. Thus, Table 1 shows that in order to ensure the adhesion as a wiring film for an electronic device, the ratio of the partial pressure of the oxygen gas to the partial pressure of the sputtering gas is required to be not less than 3.0%. More particularly, it is seen that when such high adhesion that not less than 90% of the barrier film may be left without being peeled is required, the ratio of the partial pressure of the oxygen gas to the partial pressure of the sputtering gas need not be less than 10%.

### <Resistance value>

Resistivity of each barrier film 22 annealed at 350°C was measured. Measuring results thereof are given in the following table 2.
Tab.2

**Table 2 : Resistivity**

| O₂ ratio [%] | After annealing at 350°C |
|---|---|
| | Resistivity [*µ*Ω cm] |
| 0 | 2.1 |
| 1.0 | 4.0 |
| 3.0 | 6.0 |
| 10.0 | 7.2 |
| 20.0 | 8.0 |

The higher the partial pressure of the oxygen gas, the greater the resistivity. Looking at Table 2, when the ratio of the partial pressure of the oxygen gas to the partial pressure of the sputtering gas is 20.0%, the resistivity is at a maximum of 8.0. This value shows that the film is usable as a barrier film of the above wiring film for an electronic device.

### <Film composition>

With respect to three kinds of barrier films formed at different partial pressure of the oxygen gas, the content of oxygen atoms and that of copper atoms were measured by an XPS method (X-ray photoelectron spectroscopy). Results thereof are given in the following Table 3.

### Tab. 3

**Table 3 : Film composition**

| O₂ ratio[%] | Cu[Atomic%] | O[Atomic%] |
|---|---|---|
| 5 | 96.2 | 3.8 |
| 10 | 94.9 | 5.1 |
| 15 | 90.5 | 9.5 |

It was confirmed from the above Table 3 that as the partial pressure of the oxygen gas at the time of sputtering increases, the content of oxygen atoms contained in the barrier films 22 becomes greater.

## Claims

1. A wiring film-forming process for forming a wiring film on that surface of an object to form a film thereon to which silicon or silicon dioxide is exposed, the wiring film-forming process comprising the steps of:
introducing an oxide gas and a sputtering gas into a vacuum atmosphere in which the object to form a film thereon is disposed, sputtering a first pure copper target in the vacuum atmosphere including oxygen, forming a barrier film on a surface of the object to form a film thereon,
thereafter sputtering a second pure copper target in a state such that the introduction of oxygen into a vacuum atmosphere in which the object to form a film thereon is disposed is stopped, forming a low-resistance film on a surface of the barrier film,
etching the barrier film and the low-resistance film, and thereby forming the wiring film.

2. The wiring film-forming process set forth in claim 1,
wherein an identical target is used as the first and second pure targets, and the formation of the barrier film and the formation of the low-resistance film are performed inside the same vacuum chamber.

3. The wiring film-forming process set forth in claim 1,
wherein the barrier film is formed by sputtering the first copper target, while an oxygen gas introduced such that a ratio of the partial pressure of the oxygen gas to the partial pressure of the sputtering gas in the vacuum atmosphere is at least 3.0%.

4. The wiring film-forming process set forth in claim 1,
wherein after the low-resistance film is formed, the oxygen gas and the sputtering gas are introduced into the vacuum atmosphere in which the object to form a film thereon is disposed, an adhering film is formed on a surface of the low-resistance film by sputtering a third pure copper target in a vacuum atmosphere including oxygen, and thereafter the wiring film is formed by etching the barrier film, the low-resistance film and the adhering film.

5. The wiring film-forming process set forth in claim 4,
wherein a same target is used as the first to third pure copper targets, and wherein the formation of the barrier film, the formation of the low-resistance film and the formation of the adhering film are performed inside the same vacuum chamber.

6. The wiring film-forming process set forth in claim 4,
wherein separate targets are used as the first to third pure copper targets, and the formation of the barrier film, the formation of the low-resistance film and the formation of the adhering film are performed inside discrete vacuum chambers.

7. The wiring film-forming process set forth in claim 4,
wherein
an identical target is used as the first and third pure copper targets,
another target, different from that used as the first and third pure copper targets, is used as the second pure copper target,
the formation of the barrier film and the formation of the adhering film are performed in the same vacuum chamber, and
the formation of the low-resistance film is performed in another vacuum chamber, which is different from the vacuum chamber used for the formation of the barrier film and the adhering film.

8. A transistor, comprising:
a gate electrode,
a drain semiconductor layer and a source semiconductor layer composed of semiconductors, respectively,
wherein the drain semiconductor layer and the source semiconductor layer are configured to be cut off or electrically turned on therebetween by applying a voltage to the gate electrode,
wherein a barrier film having copper as a main component and including oxygen, is formed on at least one of the surfaces of the drain semiconductor layer and that of the source semiconductor layer, and
a low-resistance layer comprising copper as a main component and having a resistance lower than that of the barrier film is formed is formed on a surface of the barrier film.

9. The transistor set forth in claim 8, wherein an adhering film comprising copper as a main component and containing oxygen is formed on either one or both of surfaces of the low-resistance film on the source semiconductor film and the low-resistance film on the drain semiconductor layer.

10. A transistor comprising
a gate electrode,
a drain semiconductor layer composed of a semiconductor, and
a source semiconductor electrode composed of a semiconductor,
the drain semiconductor layer and the source semiconductor layer being configured to be cut off or electrically turned on therebetween by applying a voltage to the gate electrode, and
the gate electrode contacting a glass substrate,
wherein the gate electrode comprises a barrier film formed on a surface of the glass substrate and a low-resistance film formed on a surface of the barrier film,
wherein the barrier film comprises copper as a main component and includes oxygen, and
wherein the low-resistance film comprises copper as a main component and has a resistance lower than that of the barrier film.

11. An electronic device comprising a transistor,
the transistor comprising a gate electrode,
a drain semiconductor layer and a source electroconductive layer composed of semiconductors, respectively,
the drain semiconductor layer and the source semiconductor layer being configured to be cut off or electrically turned on therebetween by applying a voltage to the gate electrode,
wherein a barrier film comprising copper as a main component and including oxygen is formed on at least one of the surfaces of the drain semiconductor layer and the source semiconductor layer, and
a low-resistance film having copper as a main component and having a resistance lower than that of the barrier film is formed on a surface of the barrier film.

12. An electronic device, comprising a transistor,
the transistor including a gate electrode,
a drain semiconductor layer composed of a semiconductor and
a source semiconductor layer composed of a semiconductor,
the drain semiconductor layer and the source semiconductor layer being configured to be cut off or electrically turned on therebetween by applying a voltage to the gate electrode, and the gate electrode contacting a glass substrate,
wherein the gate electrode comprises a barrier film formed on a surface of the glass substrate and a low-resistance film formed on a surface of the barrier film,
wherein the barrier film comprises copper as a main component and includes oxygen, and
wherein the low-resistance film comprises copper as a main component and has a resistance lower than that of the barrier film.

13. An electronic device comprising a glass substrate, a transparent pixel electrode arranged on the glass substrate, liquid crystals disposed on the pixel electrode, a transparent common electrode arranged on the liquid crystals, and a storage electrode tightly adhered to the glass substrate,
wherein a storage capacity having the storage electrode as a one-side electrode is connected to a liquid crystal capacity formed between the pixel electrode and the storage electrode,
and the orientation of the liquid crystals is controlled by charging and discharging the liquid crystal capacity,
wherein the storage electrode comprises a barrier film formed on a surface of the glass substrate and a low-resistance film formed on a surface of the barrier film,
wherein the barrier film comprises copper as a main component and includes oxygen, and
wherein the low-resistance film comprises copper as a main component and has a resistance lower than that of the barrier film.
